# EUROPEAN PATENT SPECIFICATION

(11) **EP 3 318 152 B1**
(45) Date of publication and mention of the grant of the patent: **27.01.2021**
(21) Application number: 17199956.8
(22) Date of filing: 03.11.2017
(51) Int. Cl.: A43D 1/02

(54) **APPARATUS AND METHOD FOR REVERSIBLY MODIFYING THE OPTICAL APPEARANCE OF A SHOE**
VORRICHTUNG UND VERFAHREN ZUR REVERSIBLEN MODIFIZIERUNG DES OPTISCHEN ERSCHEINUNGSBILDES EINES SCHUHES
APPAREIL ET PROCÉDÉ DE MODIFICATION RÉVERSIBLE DE L'ASPECT OPTIQUE D'UNE CHAUSSURE

(30) Priority: 04.11.2016 DE 102016221669
(43) Date of publication of application: 09.05.2018
(73) Proprietor: Adidas AG, 91074 Herzogenaurach (DE)
(72) Inventor: HILL, Jan, 91074 Herzogenaurach (DE); DYCKMANS, Clemens Paul, 91074 Herzogenaurach (DE)
(74) Representative: Bardehle Pagenberg Partnerschaft mbB Patentanwälte Rechtsanwälte

(56) References cited:
- GB-A- 2 395 261
- US-A1- 2013 144 424
- US-B1- 7 079 114

## Description

### Field of Invention

The present invention relates to an apparatus and a method for reversibly modifying the optical appearance of a shoe.

### Prior Art

Nowadays providing individual designs for pieces of apparel is an important factor for customer satisfaction. Therefore, many efforts are made by the industry to involve customers in the design process of a piece of apparel as early as possible, allowing a customer to develop its own unique apparel design.

A common approach is to use computer-aided methods that allow visually modelling design proposals, e.g. in a 3D modelling software. The models can then be provided with colors, textures, patterns, images, etc. to create an almost realistic impression of the piece of apparel. However, a meaningful evaluation of apparel designs on a computer screen is difficult. On the one hand, controlling a corresponding 3D modelling software requires advanced computer skills. On the other hand, a computer screen can only provide an approximate impression of the piece of apparel.

To provide customers and apparel designer with a more realistic impression of a piece or apparel before it is manufactured, real prototypes of the piece of apparel have to be produced. However, such prototypes are typically inflexible because it is difficult or even impossible to modify them, if changes in the design are desired.

Therefore, methods and systems have been developed to project a design onto a 3D model of a piece of apparel in order to change its appearance by changing the projection.

Such a projecting method and apparatus is disclosed by the online article "Mirror Mirror", available on http://mid.kaist.ac.kr/projects/mirror/, last visited on August 3, 2016.

A further projecting method and apparatus is disclosed by the online article "Projection-Based Augmented Reality FTW!", available on http://www.augmented.org/blog/2012/06/projection-based-augmented-reality-ftw/, last visited on August 4, 2016, wherein colors are projected onto the surface of a shoe.

Further prior art documents are US 7,079,114 B1, US 2013/0132038 A1, US 2015/0135447 A1, US 2012/0053716 A1, US 2013/0144424 A1, US 9,460,557 B1, and US 2016/0292779 A1.

However, the described systems still have major limitations regarding the flexibility for a designer and / or customer to freely modify the overall design of the piece of apparel and to obtain a realistic impression of its final appearance.

Therefore, the underlying object of the present invention is to provide an improved apparatus and a corresponding method for reversibly modifying the appearance of a piece of apparel.

### Summary

The invention relates to an apparatus for reversibly modifying the appearance of a shoe as specified in appended independent claim 1 and to a method for reversibly modifying the appearance of a shoe as specified in appended independent claim 9. Preferred embodiments of the invention are disclosed in the dependent claims.

Besides changing a projection, applicant has found out that enabling a modification of the shape, in particular the surface of the piece of apparel may further improve the overall design process. The piece of apparel may for example be provided as an essentially single-colored physical 3D model that may be composed of a plurality of connectable individual elements. In one embodiment, the piece of apparel can be a white or essentially single-colored piece of garment. Having an adjustable shape of the piece of apparel, facilitate the evaluation of a large number of different overall designs in a limited amount of time. The step of generating a new physical 3D model from scratch for each new design proposal based on a new shape can be omitted. Instead, the shape of the piece of apparel can be modified by, for example, attaching further elements to a physical 3D (base) model and therefore changing its shape. Moreover, already attached elements may also be removed again. After such a change colors, patterns, texture, images, etc. may be projected again onto the modified shape of the piece of apparel.

The initial position of the piece of apparel is automatically determined. Then, the projection is adjusted to be in accordance with the determined position, leading to a high-quality projection of the colors, textures, patterns, images, etc. Only the piece of apparel (and not its surrounding environment) may be illuminated by the means for projecting. This may further improve the quality of the impression of the illuminated piece of apparel, leading to an essentially realistic appearance.

While the described apparatus is suitable for evaluating designs of a shoe it may in general also be used to evaluate the designs of other physical objects, like sports devices etc.

The means for modifying the shape may comprise at least one component attachable to the piece of apparel and/or at least one component removable from the piece of apparel. In this embodiment individual components may be flexibly applied to or removed from the piece of apparel in order to modify its shape. For example, decorative elements like stripes or functional elements may be attached to the piece of apparel. Furthermore, already attached components may be removed and, for example, replaced by other components. This may enable a modification of the shape of the piece of apparel without having to rebuild it from scratch.

When the shape of the piece of apparel is modified, the means for projecting may adapt the projecting of colors, images and/or patterns in accordance with the modified shape. Projecting colors, images and/or patterns onto the piece of apparel may comprise projecting different colors, images and/or patterns to different areas of the piece of apparel.

When components are attached or removed from the piece of apparel, new areas may arise on the surface of the piece of apparel. Any area of the piece of apparel may be illuminated by an individual color, pattern or image. Furthermore, new areas may be defined by splitting existing areas into two or more new areas. In addition, existing areas can be merged to form one new single area.

The piece of apparel is a shoe and the at least one component attachable or removable to/from the shoe may comprise one or more of a heel, heel cap, a quarter, a top piece, a throat, a vamp, a welt, a side cage, a toe cap, a topline, shoelaces, a tongue, and a sole. All of these components have decisive influence on the outer appearance and thus the design of a shoe.

In addition, the at least one component attachable and/or removable to/from the piece of apparel may comprise an identification chip. The identification chip may comprise information enabling the apparatus to determine the type of the at least one component. Additionally or alternatively, the at least one component may comprise a sensor-detectable marker usable for detecting the position and/or orientation of the component.

When a component is attached to the piece of apparel, the shape of the piece of apparel may be extended (or reduced when a component is removed) and may therefore change. In such a case, a composed piece of apparel is created and the apparatus has to determine the new shape of the composed piece of apparel for adjusting the projection onto the surface of the composed piece of apparel in order to bring the projection in conformity with the new shape. However, also image analysis-based approaches may be suitable for identifying the piece of apparel or a component.

Furthermore, the at least one component may be located on a grid, wherein the grid may be observed by a visual recognition system, wherein the visual recognition system may be configured to detect that the at least one component is removed from the grid.

One or more components may be placed onto the grid. The grid may be attached to the apparatus and may be observed by a suitable visual recognition system. When one or more components are selected for being applied to the piece of apparel and are therefore removed from the grid, the apparatus may detect the removal of the component from the grid by means of the visual recognition system and therefore knows that the removed component is intended for being applied to the piece of apparel.

In addition, the apparatus may comprise means for modifying the position of the piece of apparel and/or means for accepting an input command.

When, for example, the shape and/or the projection changes, the result has to be evaluated to determine whether it meets the expectations of a customer or an apparel designer and it may be desirable to consider the piece of apparel from different perspectives. Therefore, the piece of apparel may be moved while the customer or the designer may remain at its original position.

In more detail, the change of the position may comprise a translational movement along one or more axes or a rotation of the piece of apparel along one or more rotation axes. In addition, a translational movement and a rotation may be applied simultaneously.

The change in position of the piece of apparel may be controlled by input commands applied to the apparatus enabling the customer or the apparel designer to stand still in one place while evaluating the piece of apparel from different directions.

The means for determining the position may be configured to determine a change in position of the piece of apparel and the means for projecting may be configured to adapt the projecting in accordance with the determined change in position of the piece of apparel.

For being able to adjust the projection when the piece of apparel is moved around, the change of the position may be determined. The detected change of the position may then be communicated to the means of projection, e.g. a laser device or a beamer device, or any other type of suitable projector, which may then adjust the projection to create a projection onto the surface of the moved piece of apparel at its new position. In addition, a plurality of projectors can be used such that each projector may project to a specific area of the piece of apparel.

The adjustment of the projection may be achieved by considering the distance of one or more translational movements in any direction and by considering the angle and direction of one or more rotations. Determining a change in position of the piece of apparel and/or adapting the projecting may be performed in real-time.

To maintain a suitable impression from the point of view of a customer or an apparel designer, even during movement of the piece of apparel, the determination of the change in position may be performed such that no, or at least almost no delay in adapting the projection becomes recognizable for the human eye. It is known, that the term "real-time" comprises tolerances. Therefore, a short delay in the process of determining the change in position and adapting the projection may still lead to an essentially realistic impression for a human viewer is generated so that the viewer may believe that a finally manufactured piece of apparel is moved around, and not just an illuminated model thereof.

The means for determining the position may comprise at least one of a camera configured to determine the position and/or the change in position based on image recognition, a depth sensor, preferably a photonic mixing sensor, and a marker-based tracking system, the marker-based tracking system comprising at least one sensor-detectable marker attached to the piece of apparel and/or to a component and one or more sensors usable for detecting the position and/or the change in position of the piece of apparel and/or of the components.

Using a camera may enable the use of image-based recognition algorithms for determining the position or the change in position of the piece of apparel and/or of the components. When using a depth sensor, the radiated light may be determined and corresponding algorithms may be used to determine the position or the change of position of the piece of apparel and/or of the components.

The piece of apparel may comprise one or more sensor-detectable markers. Such a marker may be a marker of commercially available position tracking system. Also a combination of different kinds of chips or markers may be comprised in and/or on the piece of apparel or the components. Then, one type of chip may be used for determining the position and orientation of the piece of apparel and/or of the components, while the other type of chip may be used for identifying the type of piece of apparel and/or of the components.

When the piece of apparel and/or the components comprise sensor-detectable markers of a position tracking system, the apparatus may determine the position and orientation of the piece of apparel (or of a piece of apparel composed by a plurality of components) without having to use the aforementioned image recognition or radiated light measurement. This may improve the position determination when insufficient lighting conditions prevail.

Furthermore, the camera-based, the depth sensor based and the sensor-based position determination may be combined. A combination of the two approaches may further improve the accuracy of the position determination, which may lead to an improved projection applied to the piece of apparel.

The means for modifying the position of the piece of apparel may be a robot arm wherein the modified position of the piece of apparel may be determined by the robot arm. The robot arm may comprise a force momentum sensor for further determining the position of the piece of apparel.

Instead of manually moving the piece of apparel for changing its position, a robot arm may be used. The robot arm may comprise a device similar to a human hand which may be configured to grab the piece of apparel. Then, the robot arm may modify the position of the piece of apparel by either reacting to movement commands provided by a customer or an apparel designer or by moving the piece of apparel along a predefined path. Using a robot arm for modifying the position may provide stable views of the piece of apparel.

Providing one or more force momentum sensors, for example in the robot arm, may further improve determining a change of the position of the piece of apparel.

Furthermore, the above described means for accepting an input command may be configured for controlling the means for projecting and/or the means for modifying the position of the piece of apparel.

Besides changing the position of the piece of apparel along a predefined path as described above in respect to the robot arm, a customer or an apparel designer may also control and change the projection applied to the piece of apparel. This may comprise changing or varying the colors, images and/or patterns projected onto the piece of apparel. In addition, contrast and saturation or any other color-related parameter may be modified.

The means for accepting an input command may be at least one area of the surface of the piece of apparel itself. Additionally or alternatively, the means for accepting an input command may be a gesture recognition system. Particularly, the input command may be submitted by a user.

To provide an intuitive way for entering input commands, the piece of apparel can be used as input device. For example, if a customer or a designer wants a specific area to be illuminated with a specific color, he may touch this area with his finger. The apparatus may then recognize this gesture and may in reaction thereto change the projected color of the area. In the same way, projected images and/or patterns may be changed.

Many different types of gestures exist that may be suitable for performing the above described actions. For example, the areas of the piece of apparel may be touch-sensitive. In this case, the areas may behave similar to common touchscreens. This may for example be achieved by the above-mentioned force momentum sensor of the robot arm. In more detail, when pressure is applied to an area of the piece of apparel held by the robot arm, the resulting force (for example a rotation force) is transmitted to the robot arm which may then determine the area of the piece of apparel to which the pressure was applied by means of the force momentum sensor. However, also touchless gesture recognition may be used. When a customer or a designer moves his finger towards a specific area or touches a specific area, the above described camera-based image recognition and/or the depth sensor may be used to determine that the finger points towards a specific area or touches the specific area. In reaction thereto, the one or more of the above described actions may be executed.

However, besides pointing or touching gestures, other gestures, like waiving etc., may be suitable for controlling the apparatus.

According to another aspect of the invention, a method for reversibly modifying the appearance of a piece of apparel is provided. The method comprises determining the position of the piece of apparel, projecting colors, images and/or patterns onto the piece of apparel, and modifying the shape of the piece of apparel, in particular its surface. Furthermore, the method may provide the optical impression that the piece of apparel is made from a material comprising the projected colors, images and/or patterns.

Modifying the shape may comprise attaching at least one component to and/or removing at least one component from the piece of apparel.

When the shape of the piece of apparel is modified, the projecting of colors, images and/or patterns may be adapted in accordance with the modified shape.

Projecting colors, images and/or patterns onto the piece of apparel may comprise projecting different colors, images and/or patterns to different areas of the piece of apparel.

The method may further comprise at least one of modifying the position of the piece of apparel and accepting an input command.

Determining the position may comprise determining a change in position of the piece of apparel and projecting may comprise adapting the projecting in accordance with the determined change in position of the piece of apparel.

Determining a change in position of the piece of apparel and/or adapting the projecting may be performed in real-time.

Accepting an input command may cause the method to modify the projecting and/or to modify the position of the piece of apparel.

The input command may be applied to at least one area of the piece of apparel itself and/or the input command may be detectable by a gesture recognition system and/or wherein the input command is submitted by a user.

This method may be performed in connection with the above described apparatus and therefore may benefit from the same aspects as already presented above in respect to said apparatus.

A further aspect not forming part of the present invention relates to a computer program that comprises instructions for performing any of the above described methods.

### Short Description of the Drawings

In the following, embodiments of the present invention are explained in detail with respect to the figures, in which:
Figs. 1 shows an apparatus according to some embodiments of the present invention;
Fig. 2 and 3 show a piece of apparel according to some embodiments of the present invention;
Fig. 4 shows a piece of apparel and components according to some embodiments of the present invention;

### Detailed Description of Embodiments

In the following, embodiments and variations of the present invention are described in detail with respect to the figures.

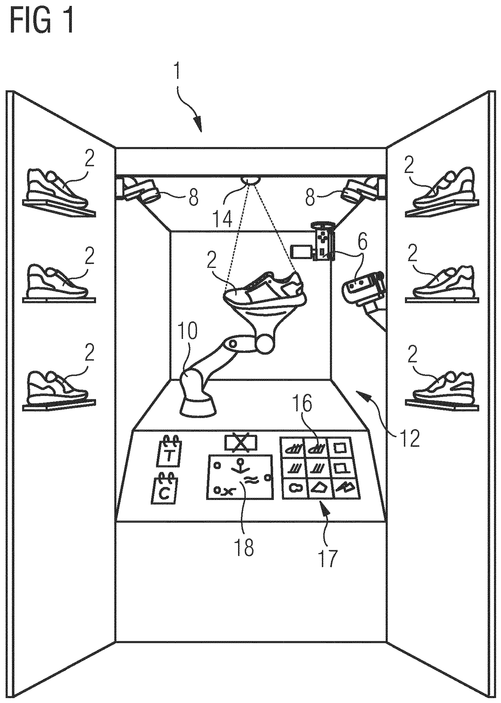

Figure 1 shows an apparatus 1 according to some embodiments of the present invention. The apparatus 1 comprises a framework 12 that surrounds a specific area in which a piece of apparel may be moved around. The piece of apparel is applied with a sensor-detectable marker 4 which can be tracked by position tracking sensors 8. In addition, one or more cameras 6 may be placed around the framework 12 to determine the position of the piece of apparel by means of image recognition. To modify the position of the piece of apparel, a robot arm 10 may be provided. Projector 14 may be used to apply a projection onto the surface of the piece of apparel, comprising colors, images and/or patterns. The apparatus 1 may be controlled by user interface 18. Furthermore, for orchestrating the interaction of all the above described devices, a computing system (not shown) may be included in apparatus 1, allowing specific calculations, receiving user input from the user interface 18 and enabling communication between the devices of apparatus 1.

As can be seen in Figure 1, a single projector 14 is placed above the piece of apparel. However, it is also possible to use more than one projectors 14 to illuminate the piece of apparel. When using more than one projector 14, it is possible to illuminate the piece of apparel inside the framework 12 from different directions at the same time. This may allow several persons to evaluate a design of the piece of apparel at the same time from different positions around the framework 12. Furthermore, when more than one projector is used, each projector may create a projection onto a specific area of the piece of apparel.

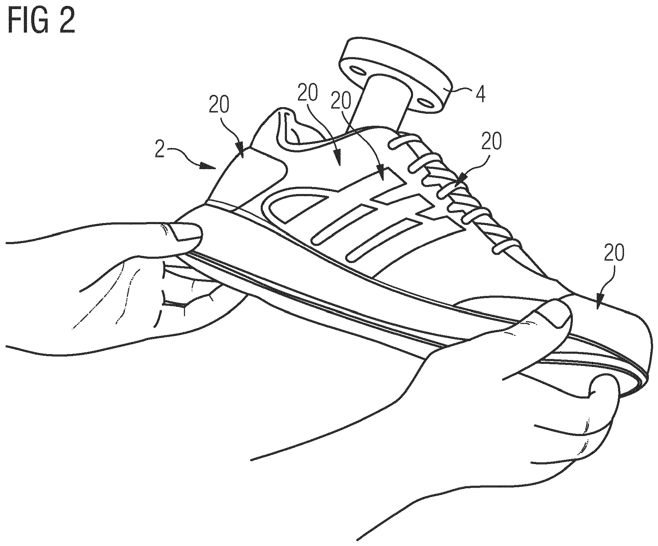

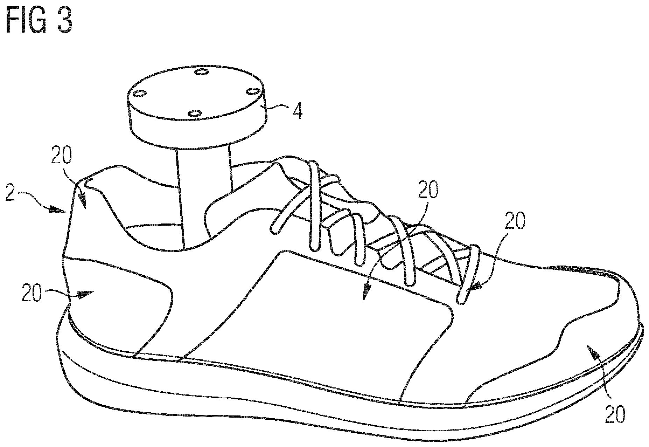

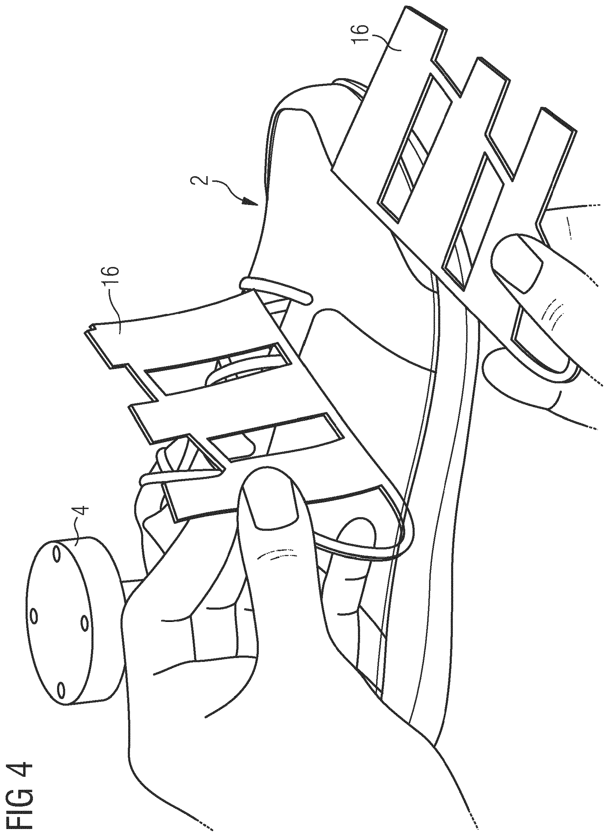

The piece of apparel can virtually be any kind of apparel. However, generally any kind of physical object, e.g. sports devices and shoes 2 can be used in connection with apparatus 1. In the following, it is assumed that the piece of apparel is a physical model of a shoe 2 according to Figures 2 - 4.

In the past, when, for example, a new shoe was developed or when a customer wanted to individually customize the appearance of a shoe, a large number of real physical models of the shoe had to be designed, manufactured, and evaluated. When the surface design or shape was considered inappropriate because the surface design or the shape didn't correspond to the wishes of the customer or apparel designer, the physical model oftentimes had to be fully discarded because it was not possible to incorporate changes of the surface design or shape into a completed physical model of a shoe 2. Therefore, a new physical model of the shoe 2 had to be manufactured for every desired change of the surface design or of the shape of the shoe.

To overcome these issue, apparatus 1 can be used for evaluating designs, comprising shape and surface designs of shoes. Before the designs can be evaluated, a physical model of the shoe 2 has to be generated. This may for example be done by means of a 3D printer. Such a printer may generate an essentially single-colored three dimensional physical model of the shoe 2. However, besides 3D printing, also any other suitable method for generating a physical model of the shoe 2 may be suitable, like casting or molding. Then, a plurality of surface designs can be applied one after another to the surface shoe 2 by means of projector 14. Projecting surface designs onto the three-dimensional physical model of the shoe 2 allows to evaluate a large number of color designs and pattern designs in a short period of time since a plurality of projections can be applied to the physical model of the shoe 2 without having to modify the physical model of shoe 2 itself.

A shoe comprises several areas 20, formed for example by its heel, its sole or its quarter etc. A desired design may define a specific color, image and/or pattern for each of said areas 20. Therefore, the one or more projectors 14 of apparatus 1 may project a first color onto a first area 20 of the surface of the physical model of the shoe 2 while a second color is projected onto a second area 20 of the physical model of the shoe 2. Generally, the number of different areas 20 is not limited. Therefore, colorful pieces of apparel can be designed, comprising a plurality of areas 20 with different colors, images and/or patterns.

While a change of a design to be projected on the surface of the physical model of the shoe 2 may only affect the colors of one or more areas 20 of its surface, another design proposal may also provide changes of the shape of the shoe. Therefore, a physical model of the shoe 2 may be produced, wherein components 16 of the shoe are exchangeable. In addition, further parts, like decorative elements etc., may be attached to the physical model of the shoe 2. These components 16 may be later-on removed again from the physical model of the shoe 2. The attachable and removable components 16 may also be produced by a 3D printer or by any other suitable means or method. The components 16 may comprise a plurality of heels, quarters, decorative elements, soles, toe caps, throats and the like. Each of the components 16 may comprise a different shape.

Then, the components 16 can be used to compose a physical model of a shoe 2 according to the specification of a specific design proposal. According to this modular principle, a plurality of different shapes of the physical model of the shoe 2 can be generated by putting together the single components 16. In addition, it is also possible to generate a base part of a physical model of a shoe 2, already comprising the final basic shape of the shoe, which may then be only applied with decorative elements.

Each component 16 may comprise one or more areas 20 to be illuminated by one or more colors, one or more images and/or one or more patterns by means of the one more projectors 14 of apparatus 1. For example, a single color may be projected onto the heel part of the physical model of the shoe 2, while a pattern is projected onto the quarter of the physical model of the shoe 2. In addition, an image may be projected onto the side part of the physical model of the shoe 2. Such an image may for example show the portrait of a famous athlete, numbers, logos, lettering etc. The patterns may comprise geometric shapes or may be used to simulate the appearance of different fabrics, like leather or plastic etc. Therefore, also the appearance of different materials can be simulated by apparatus 1.

When the physical model of the shoe 2 is completely composed, a sensor-detectable marker 4 may be incorporated into or attached to the physical model of the shoe 2. Furthermore, an identification chip, like an NFC chip, may be incorporated into or attached to the physical model of the shoe 2 allowing to identify the model type of the shoe 2. Then, the physical model of the shoe 2 may be placed into the framework 12 the apparatus 1. The apparatus 1 may then determine the position and orientation of the physical model of the shoe 2 by means of the position tracking sensors 8 that are able to detect the sensor-detectable marker 4 of the physical model of the shoe 2. The position tracking sensor 8 may belong to a position tracking system being able to determine and track the position and orientation of the marker 4 in three-dimensional space. The three-dimensional space may be formed by framework 12. The position and orientation of the sensor-detectable marker 4 corresponds to the position and orientation of the physical model of the shoe 2. When both the position and the orientation of the physical model of the shoe 2 are determined, the one or more projectors 14 may be configured to project the desired colors, images, and/or patterns onto the surface of the areas 20 of the physical model of the shoe 2.

Furthermore, each component 16 may comprise its own sensor-detectable marker 4 allowing the sensors 8 of apparatus 1 to individually determine the position and/or orientation of each component 16 forming the physical model of the shoe 2. Then, the position and orientation information of each individually tracked component 16 may be used for adjusting the projection so as to cover the shape of the composed physical model of the shoe 2.

Each component 16 may comprise its own NFC chip. A reader may be incorporated in the shoe 2 to read the respective NFC chip and identify which component is attached to the shoe. Then, the shoe 2 may communicate the detected component 16 or components 16 to the apparatus 1 by means of any suitable communication means.

Additionally or alternatively, one or more components 16 may be placed onto a grid 17 for selection. The grid 17 may be located on or near the apparatus 1. The grid 17 may be observed by one or more cameras 6 or any other visual recognition system. When one or more components 16 are selected for being applied to the physical model of the shoe 2 and therefore removed from the grid 17, apparatus 1 may detect the removal of the component 16 or components 16 from the grid 17 and therefore knows that the removed component 16 or components is/are intended for being attached to the physical model of the shoe 2. The one or more components 16 may for example be manually removed by hand. Each component 16 may have a predetermined position on the physical model of the shoe 2 to which it can be applied. When it is determined that one or more components 16 are removed from the grid 17 and applied to the physical model of the shoe 2, the apparatus 1 may instruct projector 14 to adjust the projection onto the physical model of the shoe 2 accordingly such that the one or more components 16 applied to the shoe 2 are illuminated correctly.

Besides using a position tracking system for determining and tracking the position and orientation of the marker 4, it is also possible to utilize one or more cameras 6, preferably placed around the framework 12, to determine the position and orientation of the physical model of the shoe 2 or the position and orientation of one or more components 16. Furthermore, a depth-sensor, like a photonic mixing sensor or a Microsoft Kinect® controller, may be used for determining the position and the orientation of the physical model of the shoe 2 or of the position and orientation of one or more components 16. However, also a combination of the two or more of the above presented devices for determining the position and orientation may be coupled and may therefore be used simultaneously. Then, for example filtering algorithms may be applied to determine the most accurate position value provided by one of the devices.

In particular, the cameras 6 or the depth sensor may also be able to detect the presence of any component 16 added to the physical model of the shoe 2.

After the position of the physical model of the shoe 2 and/or of the components 16 have been determined, the physical model of the shoe 2 may also be moved around in the framework 12. Then, the position and orientation may change. This may require a continuous redetection of the position and orientation to enable a corresponding adjustment of the one or more projectors 14 such that the areas 20 are still illuminated according the design being currently evaluated. Therefore, the above discussed devices (cameras 6, position tracking system, and depth sensor) may be configured for performing a detection of a change of the position, essentially in real-time.

Providing an exact projection onto the different areas 20 of the physical model of the shoe 2 requires that the one or more projectors 14 are configured according to the shape and position and/or orientation of the physical model of the shoe 2.

Therefore, the above described identification chip, e.g. an NFC chip, may provide the type of the physical model of the shoe 2 to apparatus 1. In more detail, each of the components 16 may also comprise an individual identification chip. Then, when the physical model of the shoe 2 is located inside the framework 12, apparatus 1 is able to detect the type of all the used components 16. Then, the computing device of apparatus 1 may receive shape-related information for each type of component 16 from a database. The shape-related information of the components 16 may comprise the size and the place where the components 16 may be located on the physical model of the shoe 2, as well as other appearance-related information, like a default color etc. Then, the computing device of apparatus 1 may be able to combine the shape-related information of the components 16 with a virtual 3D wireframe model of the physical model of the shoe 2. In more detail, the computing device may merge the shape-related information and the virtual 3D wireframe model of the shoe 2 so as to form one virtual object inside the computing device which may then be used as a basis for calculations required for adjusting the projection onto the physical object of the shoe 2.

In more detail, the shape-related information of the components 16 may comprise 3D wireframe data representing the geometry of the components 16. Furthermore, the physical model of the shoe 2 may also be represented by a virtual 3D wireframe model. Then, considering the virtual 3D wireframe models of both the components 16 and the physical model of the shoe 2 as well as the information regarding the place where the components 16 may be attached allows the computing device to combine the virtual 3D wireframe models of the various components 16 with the virtual 3D wireframe model of the shoe 2 to form one uniform 3D wireframe model of the overall arrangement. For example, the physical model of the shoe 2 consists of a sole, an upper part, and two decorative elements of which one is applied to the inner side and one is applied to the outer side of the shoe.

When the physical model of the shoe 2 is placed into the framework 12 of apparatus 1, all components 16 may be detected by means of the included identification chip. However, the identification may also be performed by the one or more cameras 6 using a shape detection algorithm. Then, the computing device may retrieve the shape-related information and the information regarding the place where the component 16 may be attached. A sole may commonly be placed at the bottom of the physical model of the shoe 2, whereas an upper part is commonly placed on top of the sole. Furthermore, the information regarding the place where the component 16 may be attached of the two decorative elements may define that these specific types may only be placed on the inner and outer side of the physical model of a shoe 2. Based on this information, the computing device of apparatus 1 may be able to merge the corresponding 3D wireframe model of the four components 16 to form a uniform 3D wireframe model of the physical model of the shoe 2. In addition, the 3D wireframe models of the components 16 may also define one or more areas 20 on the surface of the corresponding component 16. Therefore, the 3D wireframe model defines the overall shape as well as the different areas 20 on the surface of the physical model of the shoe 2. Such a 3D wireframe model may then be used to calculate the projections of the one or more projectors 14 of apparatus 1. This may be done by determining the position and orientation of the physical model of the shoe 2 as described above. Then this information is combined with the uniform 3D wireframe model of the physical model of the shoe 2, allowing the computing device to calculate how the projection has to be applied to the surface of the physical model of the shoe 2. The results of the calculation then allow an exact configuration of the one or more projectors 14 of apparatus 1. As a result, the one or more projectors 14 are able to project the desires colors, images and/or patterns to the corresponding areas 20 of the surface of the physical model of the shoe 2. Such a projection may create a nearly realistic impression such that human viewer may believe that he is watching at a real shoe.

Furthermore, this approach may allow to exchange components 16 of the physical model of the shoe 2 during the process of evaluating a design. In detail, a customer or an apparel designer may attach and/or remove components 16 of the physical model of the shoe 2 while being located in the framework 12 of apparatus 1. Sensor for detecting the identification chips and/or the cameras 6 may detect any change of the shape of the physical model of the shoe 2 in real-time. Therefore, the projection onto the surface may also be adjusted in real-time. When, for example, a decorative element is attached to or removed from the physical model of the shoe 2, one or more new areas 20 will arise. In reaction thereto, the one or more projectors 14 may immediately adjust the projection and will project a suitable color, image and/or pattern to the one or more new areas 20. Therefore, apparatus 1 allows customers and apparel designer to perform a seamless adjustment of the shape of the physical model of the shoe 2, without interrupting the projection.

Besides changes of the shape of the physical model of the shoe 2, it also desirable to provide a convenient way of adjusting colors, images and/or patterns of the areas 20 of the surface of the physical model of the shoe 2 during the design evaluation process.

One way of selecting colors, images and/or designs for an area 20 may be to use the user interface 18 of apparatus 1. The user interface 18 may show a picture of the physical model of the shoe 2 on a screen. This screen may be a touchscreen. Then, a customer or an apparel designer may select an area 20 of the physical model of the shoe 2 by touching the corresponding area 20 on the touchscreen. Then, the customer or apparel designer may further select a color, an image and/or a pattern to be projected onto this area 20 from a menu shown on the screen. This may cause the one or more projectors 14 to adjust the projection accordingly. The process of adjusting the projection may also be performed in real-time.

Besides a touchscreen, any other suitable input device may be used, e.g. a mouse, a keyboard etc.

A further way for selecting different colors, images and/or patterns for an area 20 is to touch this area 20 with a finger. The apparatus 1 may then recognize this gesture and may in reaction thereto change the color, image and/or pattern of the area 20.

Many different types of gestures exist that may be suitable for performing the above described changing of colors, images and gestures. For example, the areas 20 of the physical model of the shoe 2 may be touch-sensitive. In this case, the areas 20 may behave similar to common touchscreens. This may be achieved by incorporating touch-sensitive sensor into the surface of each component 16. However, also touchless gesture recognition may be used. When a customer or a designer moves his finger towards a specific area 20 or touches a specific area 20, the above described camera-based image recognition and/or the depth sensor may be used to determine that the finger points towards a specific area 20 or touches the specific area 20. In reaction thereto, the one or more of the above described actions may be executed. However, besides pointing or touching gestures, other gestures, like waiving etc., may be suitable for controlling the apparatus 1. For example, a projection may be reset by shaking the physical model of the shoe 2. This may result in a single-colored projection applied to each area 20 of the physical model of the shoe 2. In addition, the reset may lead to a projection of the original design.

In the following, the color, image and/or pattern selection is described in greater detail.

The above described gestures applied to a specific area 20 of the physical model of the shoe 2 may allow to cycle through predefined items of sets. Four types of sets may exist: Color sets, image sets, pattern sets and mixed sets.

A color set may a comprise a plurality of colors. An image set may comprise a plurality of images, like photos of famous athletes etc. Pattern sets may comprise a plurality of different patterns. A mixed set may comprise colors, images and/or patterns. These sets may be defined or modified by a customer or designer, e.g. by using the user interface 18 of apparatus 1. Furthermore, a plurality of sets may be defined per area 20.

Assuming that a color set is pre-selected, then, when a customer or designer performs a gesture as described above, the color of the corresponding area 20 may change from blue to green. When the area 20 is touched again, the color may change from green to yellow. In the same way, the user may cycle though the other types of sets. The same method may be used for cycling through image sets and pattern sets.

However, a customer may also cycle though the different types of sets. While cycling though the items of a set is performed by a first type of gesture, cycling though the sets may be performed by a second type of gesture. When a gesture according to the second type is detected, the projection onto a specific area 20 is not changed, but only a new set is activated. Then, when the first type of gesture is performed, it is cycled through the items of the activated set.

Such mechanism allows a customer or an apparel designer to quickly change the projection onto a specific area 20 without having to use the user interface 18 of apparatus 1.

Besides modifying the shape of the physical model of the shoe 2 and the projection thereon, also the position and/or orientation of the physical model of the shoe 2 may be modified. This may be done manually by grapping the physical model of the shoe 2 and moving it freely around inside the framework 12 of apparatus 1.

The position of the physical model of the shoe 2 may further be modified by means of a rotatable and/or inclinable platform on which the physical model of the shoe 2 may be placed. Such a platform may be located inside the framework 12 of apparatus 1. The platform may be controlled by entering corresponding commands using the user interface 18 of apparatus 1.

Instead of using a platform, a robot arm 10 may be used for modifying the position of the physical model of the shoe 2. The robot arm 10 may comprise a device similar to a human hand which may be configured to grab physical model of the shoe 2. Then, the robot arm 10 may modify the position of the physical model of the shoe 2 by either reacting to movement commands provided by a user or by moving the physical model of the shoe 2 along a predefined path.

The predefined path may comprise the most important positions required for sufficiently evaluating the overall design of the physical model of the shoe 2. For example, the robot arm 10 may at first lift the physical model of the shoe 2 and then rotate it such that a consumer or an apparel designer may be provided with a front view of the physical model of the shoe 2. Then, the robot arm 10 may remain in this position for a specific period of time. Afterwards, the robot arm 10 may move the physical model of the shoe 2 to a next position. Then, the robot arm 10 may again remain in this position for a specific period of time. These steps may be repeated until all predefined positions along the predefined path have been reached once.

Using a robot arm 10 or a platform as described above for modifying the position may provide stable views of the piece of apparel. In comparison, when the piece of apparel is held in hand by a customer or apparel designer, the piece of apparel may always slightly be jiggled because a human hand cannot be kept exactly in one position without any slight movement of the hand.

Furthermore, the robot arm 10 may comprise one or more force momentum sensors which may further improve determining a change of the position of the physical model of the shoe 2. The position information gathered by said sensor may be communicated to the computing device of apparatus 1. The force momentum sensor information may be used alone or in combination with the position information provided by the position tracking system, the one or more cameras 6 and/or by the depth sensor.

Furthermore, the robot arm 10 may use the force momentum sensor to determine the area on the shoe 2 to which pressure is applied. The pressure results in a force which may be transmitted to the robot arm 10, e.g. in terms of a rotation force or the like. Then, the robot arm may determine the area on the shoe 2 to which the pressure was applied by means of the force momentum sensor. Thus, the force momentum sensor may be used to implement a mechanism for determining an area of the shoe 2 that a user has selected by touching said area.

Besides a robot arm 10 or a platform, any other means are suitable for modifying the position which may push, pull, lift, rotate, and/or lower the position of the physical model of the shoe 2.

When a design has been fully evaluated and satisfies the wishes of a customer or an apparel designer, the configuration of the design, comprising the one or more components 16 that form the physical model of the shoe 2, the colors, images, and/or patterns selected for one or more areas 20, may be stored in a database. The process of storing may be initiated by using the user interface 18 of apparatus 1. The configuration may then be used to control the manufacturing process of the shoe according to the evaluated design.

One or more of the above described aspects of the present invention may be implemented in hardware, in software or as a combination of hardware or software. Furthermore, one or more of the above described aspects may be implemented in the apparatus or in terms of a method.

## Claims

1. An apparatus (1) for reversibly modifying the appearance of a shoe (2), the apparatus comprising:
a. means for automatically determining the position (4, 6, 8) of the shoe (2);
b. means for projecting colors, images and/or patterns (14) onto the shoe (2) in accordance with the determined position; and
c. means for modifying the shape (16) of the shoe (2), in particular its surface.

2. The apparatus (1) of claim 1, wherein the means for modifying the shape (16) comprise at least one component (16) attachable to the shoe (2) and/or at least one component (16) removable from the shoe (2).

3. The apparatus (1) of any of the preceding claims, wherein, when the shape of the shoe (2) is modified, the means for projecting (6, 8) is configured to adapt the projecting of the colors, images and/or patterns in accordance with the modified shape.

4. The apparatus (1) of any of the preceding claims, wherein projecting of the colors, images and/or patterns onto the shoe (2) comprises projecting different colors, images and/or patterns to different areas of the shoe (2).

5. The apparatus (1) of any of the preceding claims 2 - 4, wherein the at least one component (16) attachable and/or removable to/from the shoe (2) comprises an identification chip, the identification chip comprising information enabling the apparatus (1) to determine the type of the at least one component (16); and/or wherein the at least one component (16) comprises a sensor-detectable marker usable for detecting the position and/or orientation of the component (16).

6. The apparatus (1) of any of the preceding claims, further comprising at least one of:
- means for modifying the position of the shoe (2),
- means for accepting an input command.

7. The apparatus (1) of claim 6, wherein the means for modifying the position of the shoe (2) is a robot arm (10) and/or wherein the modified position of the shoe (2) is determined by the robot arm (10).

8. The apparatus (1) of claim 7, wherein the robot arm (10) comprises a force momentum sensor for further determining the position of the shoe (2).

9. A method for reversibly modifying the optical appearance of a shoe (2), the method comprising:
a. automatically determining the position of the shoe (2);
b. projecting colors, images and/or patterns onto the shoe (2) in accordance with the determined position; and
c. modifying the shape of the shoe (2), in particular its surface.

10. The method of claim 9, wherein modifying the shape comprises attaching at least one component (16) to and/or removing at least one component (16) from the shoe apparel (2).

11. The method of any of the preceding claims 9 - 10, wherein, when the shape of the shoe (2) is modified, the projecting of colors, images and/or patterns is adapted in accordance with the modified shape.

12. The method of any of the preceding claims 9 - 11, further comprising at least one of the following steps:
- modifying the position of the shoe (2),
- accepting an input command.

13. The method of claim 9 - 12, wherein determining the position comprises determining a change in position of the shoe (2);
and
wherein projecting comprises adapting the projecting in accordance with the determined change in position of the shoe (2).

14. The method of any of the preceding claims 12 - 13, wherein accepting an input command causes the method to modify the projecting and/or to modify the position of the shoe (2).

## Patentansprüche

1. Vorrichtung (1) zum reversiblen Modifizieren des Erscheinungsbildes eines Schuhs (2), wobei die Vorrichtung umfasst:
a. Mittel zum automatischen Bestimmen der Position (4, 6, 8) des Schuhs (2);
b. Mittel zum Projizieren von Farben, Bildern und/oder Mustern (14) auf den Schuh (2) in Übereinstimmung mit der bestimmten Position; und
c. Mittel zum Modifizieren der Form (16) des Schuhs (2), insbesondere seiner Oberfläche.

2. Vorrichtung (1) nach Anspruch 1, wobei die Mittel zum Modifizieren der Form (16) mindestens eine an dem Schuh (2) anbringbare Komponente (16) und/oder mindestens eine von dem Schuh (2) entfernbare Komponente (16) umfassen.

3. Vorrichtung (1) nach einem der vorhergehenden Ansprüche, wobei, wenn die Form des Schuhs (2) modifiziert wird, die Mittel zum Projizieren (6, 8) konfiguriert sind, um das Projizieren der Farben, Bilder und/oder Muster in Übereinstimmung mit der modifizierten Form anzupassen.

4. Vorrichtung (1) nach einem der vorhergehenden Ansprüche, wobei das Projizieren der Farben, Bilder und/oder Muster auf den Schuh (2) Projizieren verschiedener Farben, Bilder und/oder Muster auf verschiedene Bereiche des Schuhs (2) umfasst.

5. Vorrichtung (1) nach einem der vorhergehenden Ansprüche 2 - 4, wobei die mindestens eine Komponente (16), die an dem Schuh (2) anbringbar und/oder von dem Schuh (2) entfernbar ist, einen Identifikations-Chip umfasst, wobei der Identifikations-Chip Informationen umfasst, die es der Vorrichtung (1) ermöglichen, den Typ der mindestens einen Komponente (16) zu bestimmen; und/oder
wobei die mindestens eine Komponente (16) eine sensordetektierbare Markierung aufweist, die zum Detektieren der Position und/oder Ausrichtung der Komponente (16) verwendbar ist.

6. Vorrichtung (1) nach einem der vorhergehenden Ansprüche, ferner umfassend mindestens eines von:
- Mittel zum Modifizieren der Position des Schuhs (2),
- Mittel zum Akzeptieren eines Eingabebefehls.

7. Vorrichtung (1) nach Anspruch 6, wobei die Mittel zum Modifizieren der Position des Schuhs (2) ein Roboterarm (10) sind und/oder wobei die modifizierte Position des Schuhs (2) durch den Roboterarm (10) bestimmt wird.

8. Vorrichtung (1) nach Anspruch 7, wobei der Roboterarm (10) einen Kraftmomentsensor zum weiteren Bestimmen der Position des Schuhs (2) umfasst.

9. Verfahren zum reversiblen Modifizieren des optischen Erscheinungsbildes eines Schuhs (2), wobei das Verfahren umfasst:
a. automatisches Bestimmen der Position des Schuhs (2);
b. Projizieren von Farben, Bildern und/oder Mustern auf den Schuh (2) in Übereinstimmung mit der bestimmten Position; und
c. Modifizieren der Form des Schuhs (2), insbesondere seiner Oberfläche.

10. Verfahren nach Anspruch 9, wobei Modifizieren der Form Anbringen mindestens einer Komponente (16) an und/oder Entfernen mindestens einer Komponente (16) von der Schuhbekleidung (2) umfasst.

11. Verfahren nach einem der vorhergehenden Ansprüche 9 - 10, wobei, wenn die Form des Schuhs (2) modifiziert wird, das Projizieren von Farben, Bildern und/oder Mustern in Übereinstimmung mit der modifizierten Form angepasst wird.

12. Das Verfahren nach einem der vorhergehenden Ansprüche 9 - 11, ferner umfassend mindestens einen der folgenden Schritte:
- Modifizieren der Position des Schuhs (2),
- Akzeptieren eines Eingabebefehls.

13. Verfahren nach den Ansprüchen 9 - 12, wobei Bestimmen der Position Bestimmen einer Positionsänderung des Schuhs (2) umfasst;
und
wobei Projizieren Anpassen des Projizierens gemäß der bestimmten Positionsänderung des Schuhs (2) umfasst.

14. Verfahren nach einem der vorhergehenden Ansprüche 12 - 13, wobei Akzeptieren eines Eingabebefehls das Verfahren veranlasst, das Projizieren zu modifizieren und/oder die Position des Schuhs (2) zu modifizieren.

## Revendications

1. Un appareil (1) pour la modification réversible de l'aspect d'une chaussure (2), l'appareil comprenant :
a. des moyens pour déterminer automatiquement la position (4, 6, 8) de la chaussure (2) ;
b. des moyens pour projeter des couleurs, des images et/ou des motifs (14) sur la chaussure (2) en conformité avec la position déterminée ; et
c. des moyens pour modifier la forme (16) de la chaussure (2), en particulier sa surface.

2. L'appareil (1) de la revendication 1, dans lequel les moyens pour modifier la forme (16) comprennent au moins un composant (16) qui peut être monté sur la chaussure (2) et/ou au moins un composant (16) qui peut être séparé de la chaussure (2).

3. L'appareil (1) de l'une des revendications précédentes, dans lequel, lorsque la forme de la chaussure (2) est modifiée, les moyens pour projeter (6, 8) sont configurés pour adapter la projection des couleurs, des images et/ou des motifs en conformité avec la forme modifiée.

4. L'appareil (1) de l'une des revendications précédentes, dans lequel la projection des couleurs, des images et/ou des motifs sur la chaussure (2) comprend la projection de couleurs, images et/ou motifs différents sur des zones différentes de la chaussure.

5. L'appareil (1) de l'une des revendications précédentes 2 à 4, dans lequel l'au moins un composant (16) qui peut être monté sur, et/ou séparé de, la chaussure (2) comprend une puce d'identification, la puce d'identification comprenant des informations permettant à l'appareil (1) de déterminer le type de l'au moins un composant (16) ; et/ou dans lequel l'au moins un composant (16) comprend un marqueur détectable par capteur utilisable pour détecter la position et/ou l'orientation du composant (16).

6. L'appareil (1) de l'une des revendications précédentes, comprenant en outre au moins l'un d'entre :
- des moyens pour modifier la position de la chaussure (2) ;
- des moyens pour recevoir une commande en entrée.

7. L'appareil (1) de la revendication 6, dans lequel les moyens pour modifier la position de la chaussure (2) sont un bras robotisé (10) et/ou dans lequel la position modifiée de la chaussure (2) est déterminée par le bras robotisé (10).

8. L'appareil (1) de la revendication 7, dans lequel le bras robotisé (10) comprend un capteur de quantité de mouvement de force pour déterminer en outre la position de la chaussure (2).

9. Un procédé de modification réversible de l'aspect d'une chaussure (2), le procédé comprenant :
a. la détermination automatique de la position de la chaussure (2) ;
b. la projection de couleurs, d'images et/ou de motifs sur la chaussure (2) en conformité avec la position déterminée ; et
c. la modification de la forme de la chaussure (2), en particulier de sa surface.

10. Le procédé de la revendication 9, dans lequel la modification de la forme comprend le montage d'au moins un composant (16) sur, et/ou la séparation d'au moins un composant (16) d'avec, l'article chaussant (2).

11. Le procédé de l'une des revendications précédentes 9 à 10, dans lequel, lorsque la forme de la chaussure (2) est modifiée, la projection des couleurs, images et/ou motifs est adaptée en conformité avec la forme modifiée.

12. Le procédé de l'une des revendications précédentes 9 à 11, comprenant au moins l'une des étapes suivantes :
- la modification de la position de la chaussure (2),
- la réception d'une commande en entrée.

13. Le procédé des revendications 9 à 12, dans lequel la détermination de la position comprend la détermination d'un changement de position de la chaussure (2) ;
et dans lequel la projection comprend l'adaptation de la projection en conformité avec la modification déterminée de la position de la chaussure (2).

14. Le procédé de l'une des revendications précédentes 12 à 13, dans lequel la réception d'une commande d'entrée fait en sorte que le procédé modifie la projection et/ou modifie la position de la chaussure (2).
